## Europäisches Patentamt

## European Patent Office

## Office européen des brevets

(19)

(11) Numéro de publication: **0 093 029**
**B1**

(12) # FASCICULE DE BREVET EUROPEEN

(45) Date de publication du fascicule du brevet:
**04.12.85**

(51) Int. Cl.⁴: **H 01 L 23/32,** H 01 L 25/16,
H 01 J 7/24

(21) Numéro de dépôt: **83400613.2**

(22) Date de dépôt: **24.03.83**

(54) **Régulateur électronique pour alternateurs de véhicules automobiles.**

(30) Priorité: **22.04.82 FR 8206900**

(43) Date de publication de la demande:
**02.11.83 Bulletin 83/44**

(45) Mention de la délivrance du brevet:
**04.12.85 Bulletin 85/49**

(84) Etats contractants désignés:
**BE DE GB IT**

(56) Documents cités:
**DE - A - 2 652 077
DE - A - 2 823 666
FR - A - 2 344 174
US - A - 3 420 942
US - A - 4 115 838**

(73) Titulaire: **DUCELLIER & Cie, Echat 950, F-94024 Créteil Cedex (FR)**

(72) Inventeur: **Couvertier, Jean Louis, 1, Rue Pasteur, F-92600 Asnieres (FR)**

(74) Mandataire: **Habert, Roger, VALEO Service Propriété Industrielle 21 rue Auguste Blanqui, F-93406 Saint Ouen (FR)**

## Description

L'invention concerne un régulateur électronique comprenant un socle de fixation du régulateur sur la carrosserie du véhicule, un boitier ou capot isolant dans lequel est noyé, dans une résine, un circuit de régulation de la tension de sortie d'un alternateur et des liaisons de raccordement à des connexions de branchement à la masse du véhicule, à la clé de contact du véhicule et à l'enroulement de champ de l'alternateur.

Sur les véhicules automobiles, depuis quelques années, les régulateurs électromagnétiques sont remplacés, en majeure partie, par des régulateurs électroniques lesquels présentent l'avantage d'être pratiquement indéréglables et d'avoir une durée de vie plus importante en raison du fait qu'ils ne comportent pas de grains de contact qui se détériorent sous l'effet de l'arc électrique dû à la coupure du courant circulant dans l'enroulement de champ de l'alternateur.

Lorsque le régulateur électronique doit être fixé, sur le véhicule à la même place que le régulateur électromagnétique qu'il remplace, on utilise le socle de fixation en tôle d'acier et les connexions de branchement primitivement prévus pour le régulateur électromagnétique.

Ces connexions de branchement obtenues à partir de barrettes découpées dans de la tôle d'acier, sont isolées électriquement entre elles et par rapport au socle de fixation, en tôle d'acier, au moyen de plaques isolantes, le tout étant solidarisé par des rivets.

Le boitier contenant le circuit de régulation est ensuite fixé sur le socle au moyen de vis ou de rivets.

Ce mode de réalisation du socle de fixation et des connexions de branchement qui nécessite des opérations de découpage, d'assemblage et de rivetage représente une part non négligeable du coût de fabrication de tels régulateurs.

L'invention a pour but de remédier à cet inconvénient par la suppression du socle métallique et en conséquence par la suppression des plaques isolantes et des rivets d'assemblage.

A cet effet l'invention a, conformément à la revendications 1, pour objet un régulateur électronique caractérisé en ce que le boitier isolant comporte des moyens de fixation sur le socle; des moyens de logement de chacune de l'une des extrémités des connexions de branchement et en ce que le socle, en matière isolante moulée, comporte des pattes et des moyens de logement de chacune des autres extrémités des connexions de branchement.

Des exemples de réalisation de l'invention, correspondant aux revendications dependantes, comportent les détails constructifs particuliers ci-dessous.

Les moyens de fixation du boitier isolant, sur le socle, sont constitués d'excroissances venant de matière avec le boitier isolant, lesquelles excroissances comportent une première partie cylindrique, de longueur sensiblement égale à la moitié de la longueur totale des excroissances et une deuxième partie cylindrique dont la grande base est de diamètre plus important que la première partie cylindrique, au moins une fente longitudinale étant prévue sur la majeure partie de la longueur totale des excroissances.

Les moyens de logement de chacune de l'une des extrémités des connexions de branchement, dans le boitier isolant, sont constitués de glissières obtenues lors du moulage de la matière constituant le boitier isolant, lesquelles glissières sont ménagées dans les parois dudit boitier.

Le moyen de logement de l'autre extrémité d'une des connexions de branchement est constitué d'un évidement prévu dans le socle, lors du moulage de celui-ci, lequel évidement comprend deux parties d'inégale profondeur.

Le moyen de logement de l'autre extrémité d'une des connexions de branchement est constitué par la différence d'épaisseur de l'une des pattes de fixation par rapport à l'autre, laquelle différence d'épaisseur est obtenue lors du moulage du socle. Le moyen de logement de l'autre extrémité d'une des connexions de branchement est constitué d'un déchrochement obtenu lors du moulage du socle.

Le branchement à la masse du régulateur est effectué par l'intermédiaire d'une connexion de branchement et d'une douille métallique dans laquelle pénètre librement et vient prendre appui la tête d'une des vis de fixation du socle sur la carrosserie du véhicule automobile.

L'avantage obtenu par cette invention est que l'on diminue le coût de fabrication de tels régulateurs.

La description qui va suivre en regard des dessins annexés fera mieux comprendre comment l'invention peut être réalisée.

La figure 1 est la vue en coupe longitudinale, selon la ligne AA de la figure 2, d'un régulateur objet de l'invention.

La figure 2 est la vue de dessus du régulateur selon la figure 1.

La figure 3 est la vue de dessous du capot isolant selon un mode de réalisation des moyens de fixation du capot isolant sur le socle.

La figure 4 est la représentation agrandie, selon la ligne bb de la figure 3, des moyens de fixation du boitier isolant sur le socle.

La figure 5 est une vue en perspective du socle et des connexions de branchement.

La figure 6 est une vue de dessous du capot isolant selon un autre mode de réalisation des moyens de fixation du capot isolant sur le socle.

La figure 7 est une vue en coupe longitudinale, selon la ligne CC du capot isolant représenté par la figure 6.

La figure 8 est une vue agrandie des pattes de maintien, par encliquetage du circuit de régulation dans le capot isolant.

La figure 9 est une vue agrandie de l'autre mode de réalisation des moyens de fixation du capot isolant tels que représentés sur les figures 6 et 7.

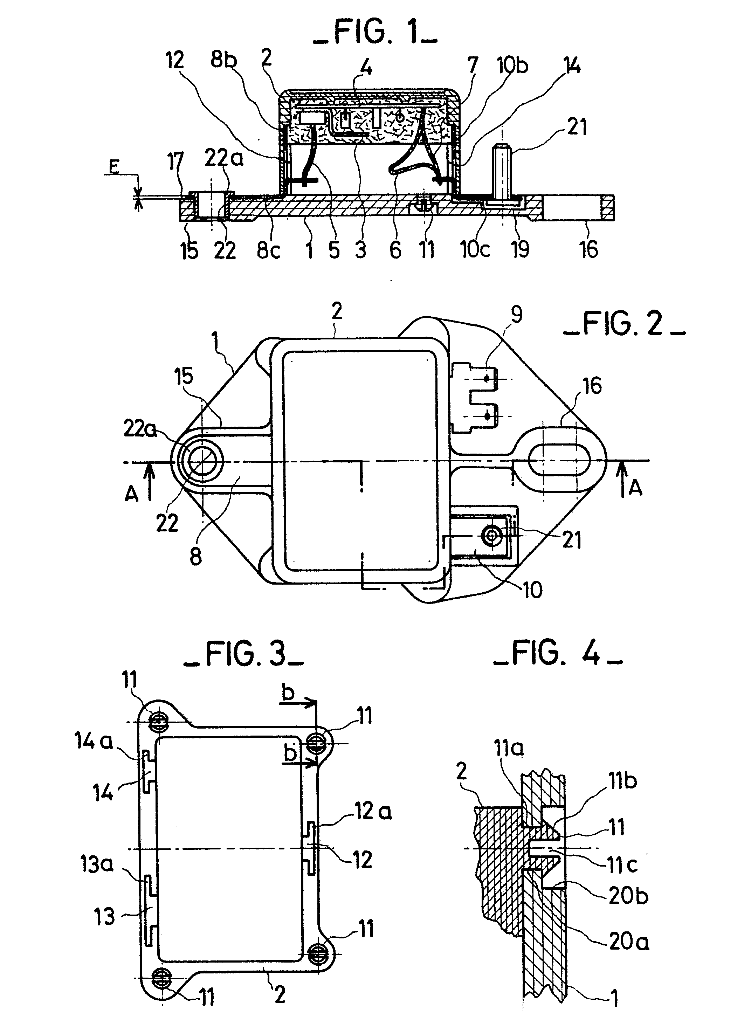

Le régulateur représenté par les figures 1 et 2 comprend un socle de fixation 1 du régulateur sur la carrosserie du véhicule, un boitier isolant 2 dans lequel est noyé dans une résine 3, du genre Epoxy, un circuit de régulation 4 comportant des éléments semi-conducteurs et des éléments résistifs qui assurent la régulation de la tension de sortie d'un alternateur, non représenté.

Des liaisons 5, 6 et 7 de raccordement reliées électriquement au circuit de régulation 4 sont connectées à des connexions de branchement 8, 9 et 10.

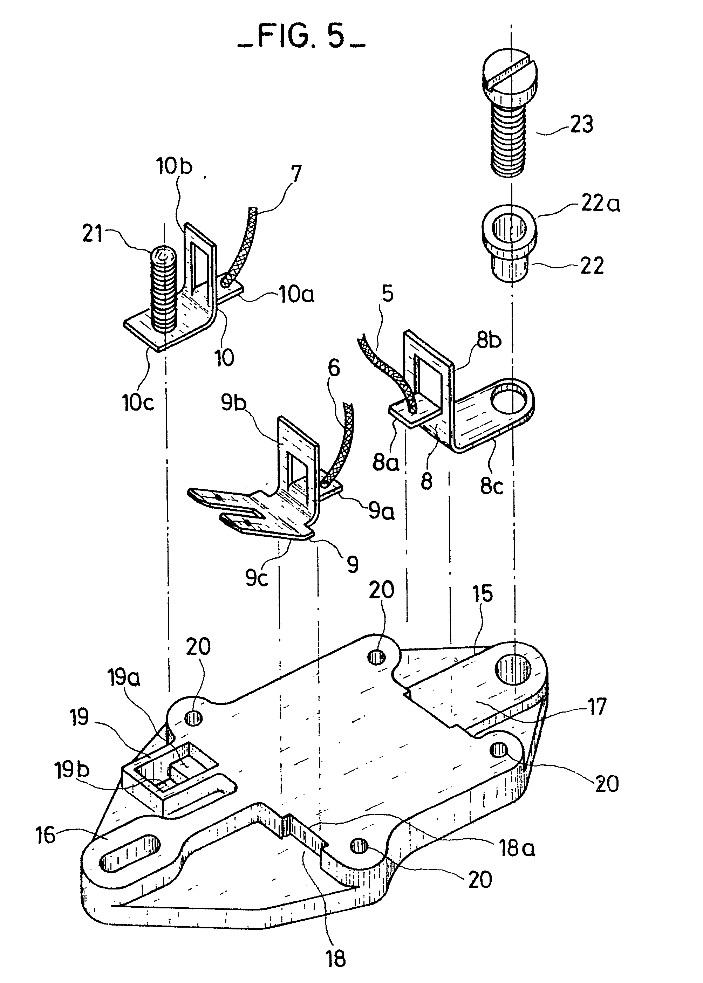

La liaison 5 est connectée à la connexion 8, par l'intermédiaire d'une patte 8a munie d'un trou dans lequel est soudée l'extrémité de la liaison 5, figure 5, de manière à assurer le branchement du régulateur à la masse du véhicule.

La liaison 6 est connectée à la connexion 9, par l'intermédiaire d'une patte 9a munie d'un trou dans lequel est soudée l'extrémité de la liaison 6, figure 5, de manière à assurer, par l'intermédiaire d'un câble, non représenté, le branchement du régulateur à la clé de contact, non représentée, du véhicule.

La liaison 7 est connectée à la connexion 10, par l'intermédiaire d'une patte 10a munie d'un trou dans lequel est soudée l'extrémité de la liaison 7, figure 5, de manière à assurer par l'intermédiaire d'un cable, non représenté, le branchement du régulateur à l'enroulement de champ de l'alternateur, non représenté.

Selon un mode préféré de réalisation de l'invention, le boitier isolant 2, moulé avec une matière telle que du polypropylène, comporte des moyens 11 de fixation sur le socle 1, figures 3 et 4, et des moyens de logement 12, 13 et 14, figure 3, de chacune des extrémités 8b, 9b et 10b, figure 5, des connexions de branchement 8, 9 et 10.

Le socle 1 prévu sous la forme d'une plaque en matière isolante moulée, telle par exemple que du polypropylène, comporte des pattes 15 et 16, munies de trous figures 1, 2 et 5, pour sa fixation par vis sur la carrosserie du véhicule et des moyens de logement 17, 18 et 19 de chacune des extrémités 8c, 9c et 10c des connexions de branchement 8, 9 et 10.

Les moyens 11 de fixation du boitier isolant 2, sur le socle 1 sont constitués d'excroissances venant de matière lors du moulage dudit boitier 2, lesquelles excroissances comportent une première partie 11a cylindrique, de longueur sensiblement égale à la moitié de la longueur des excroissances et une deuxième partie 11b cylindroconique dont la grande base est de diamètre plus important que la première partie cylindrique 11a.

Au moins une fente longitudinale 11c est prévue sur la majeure partie de la longueur des excroissances de manière que lors de la pénétration des excroissances dans des trous 20 prévus sur le socle 1, figure 5, les excroissances puissent se rétracter, par l'intermédiaire de la fente longitudinale 11c dans la partie 20a des trous 20 et revenir à leur état initial dans la partie 20b de façon à réaliser une fixation par encliquetage du boitier isolant 2 sur le socle de fixation 1, figure 4.

Les moyens de logement 12, 13 et 14 des extrémités 8b, 9b et 10b des connexions de branchement 8, 9 et 10 dans le boitier isolant 2, sont constitués de glissières 12a, 13a et 14a, figure 3, obtenues lors du moulage du boitier isolant 2, lesquelles glissières 12a, 13a et 14a sont ménagées dans les parois du boitier isolant 2.

Le moyen de logement 17, figures 1 et 5, de l'extrémité 8c de la connexion de branchement 8 est constitué par la différence d'épaisseur E, figure 1, de la patte 15 par rapport à la patte 16, laquelle différence d'épaisseur E est obtenue lors du moulage du socle de fixation 1.

Le moyen de logement 18, figure 5, de l'extrémité 9c de la connexion de branchement 9 est constitué d'un décrochement 18a obtenu lors du moulage du socle de fixation 1.

Le moyen de logement 19, figures 1 et 5, de l'extrémité 10c de la connexion de branchement 10 est constitué d'un évidement prévu lors du moulage du socle de fixation 1, lequel évidement comprend deux parties 19a, 19b d'inégale profondeur, la partie 19a étant de profondeur supérieure à l'épaisseur de la connexion de branchement 10, la partie 19b étant de profondeur supérieure à la hauteur de la tête d'une vis 21 solidaire de la connexion de branchement 10. Le branchement à la masse du régulateur est assuré par l'intermédiaire de la connexion de branchement 8 et d'une douille métallique 22 dans laquelle pénètre librement une vis 23 dont la tête vient prendre appui sur la collerette 22a, laquelle vis 23 est vissée dans la carrosserie du véhicule.

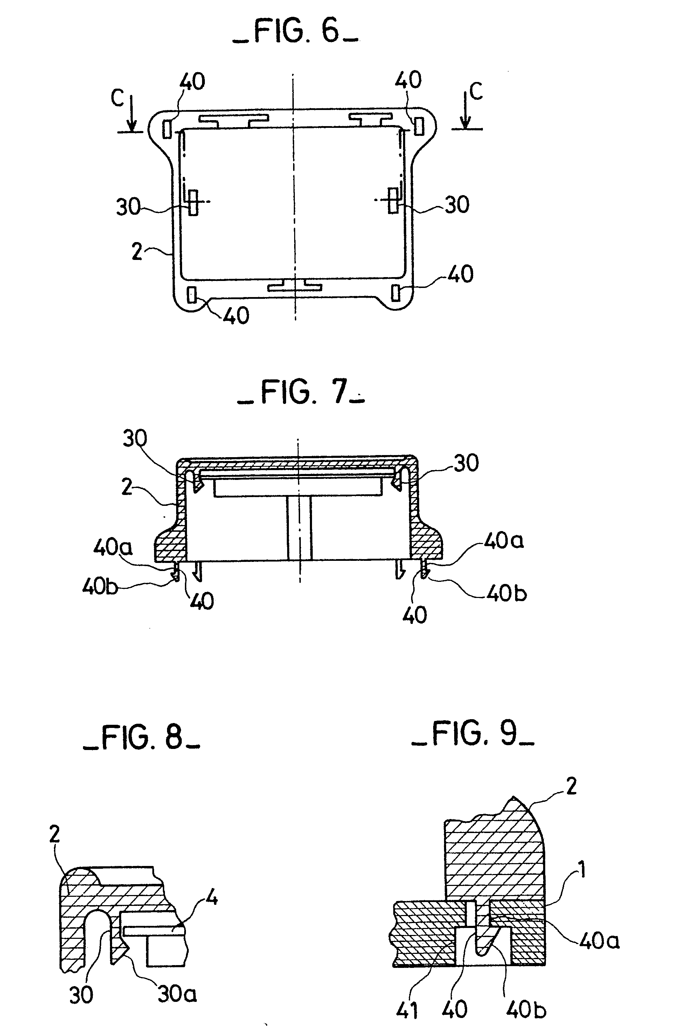

Le boitier isolant 2, figures 6, 7 et 8, comporte des moyens 30 de maintien élastique du circuit de régulation 4.

Dans un mode préféré de réalisation de l'invention, les moyens 30 sont constitués de pattes, venant de matière avec le boitier isolant 2. Ces pattes sont munies d'un becquet d'accrochage 30a dans lesquels on encliquete, par pression, le circuit de régulation 4, pour éviter que ledit circuit 4 ne se déplace sous l'effet de la poussée de la résine 3 lors de sa coulée dans le boitier isolant 2. Dans un autre mode de réalisation, figures 6, 7 et 9, des moyens de fixation du boitier isolant 2, sur le socle de fixation 1, ceux ci sont constitués de languettes 40, venant de matière avec le boitier isolant 2, lesquelles languettes 40 comportent une première partie 40a, d'épaisseur constante et de longueur sensiblement égale à la moitié de la longueur totale des languettes et une deuxième partie extrême formant un becquet d'accrochage 40b dans des logements 41 prévus dans le socle de fixation 1 et sur le fond de chacun desquels prend appui le becquet d'accrochage 40b, voir figure 9.

En raison des différents modes de fixation des régulateurs sur les véhicules automobiles, il est évident que le socle 1 peut être prévu, soit avec une seule patte comportant deux trous de passage des vis de fixation, soit avec une queue d'aronde qui s'emboite dans le logement existant sur les batteries de certains véhicules automobiles.

## Revendications

1. Régulateur électronique pour alternateurs de véhicules automobiles, régulateur comprenant: un socle (1) de fixation du régulateur sur la carrosserie du véhicule; un boitier ou capot isolant (2) dans lequel est noyé, dans une résine (3) un circuit de régulation (4) de la tension de sortie d'un alternateur; des liaisons (5, 6 et 7) de raccordement à des connexions de branchement (8, 9 et 10) à la masse du véhicule et, par l'intermédiaire de câbles, à la clé de contact du véhicule et à l'enroulement de champ de l'alternateur, caractérisé en ce que le boitier isolant (2) comporte des moyens (11; 40) de fixation sur le socle (1) à l'aide de moyens correspondants (20; 41) de celui-à; des moyens de logement (12, 13, 14) de chacune de l'une des extrémités (8b, 9b, 10b) des connexions de branchement (8, 9 et 10) et en ce que le socle (1) en matière isolante moulée, comporte des pattes de fixation (15, 16) sur la carrosserie du véhicule et des moyens de logement (17, 18 et 19) de chacune des autres extrémités (8c, 9c, 10c) des connexions de branchement (8, 9 et 10).

2. Régulateur selon la revendication 1, caractérisé en ce que les moyens (11) de fixation du boitier isolant (2) sur le socle (1) sont constitués d'excroissances venant de matière avec le boitier isolant (2) lesquelles excroissances comportent une première partie (11a) cylindrique, de longueur sensiblement égale à la moitié de la longueur des excroissances et une deuxième partie (11b) cylindroconique dont la grande base est de diamètre plus important que la première partie (11a) cylindrique, au moins une fente longitudinale (11c) étant prévue sur la majeure partie de la longueur des excroissances.

3. Régulateur selon la revendication 1, caractérisé en ce que les moyens de logement (12, 13 et 14) des extrémités (8b, 9b, 10b) des connexions de branchement (8, 9 et 10) dans le boitier isolant (2) sont constitués de glissières (12a, 13a et 14a) obtenues lors du moulage du boitier isolant (2), lesquelles glissières (12a, 13a et 14a) sont ménagées dans les parois du boitier isolant (2).

4. Régulateur selon la revendication 1, caractérisé en ce que le moyen de logement (17) de l'extrémité (8c) de la connexion de branchement (8) est constitué par la différence d'épaisseur E de la patte (15) par rapport à la patte (16) laquelle différence d'épaisseur E est obtenue lors du moulage du socle (1).

5. Régulateur selon la revendication 1, caractérisé en ce que le moyen de logement (18) de l'extrémité (9c) de la connexion de branchement (9) est constitué d'un déchrochement (18a) obtenu lors du moulage du socle (1).

6. Régulateur selon la revendications 1, caractérisé en ce que le moyen de logement (19) de l'extrémité (10c) de la connexion de branchement (10) est constitué d'un évidement prévu dans le socle (1) lors du moulage de celui-ci, lequel évidement comprend deux parties (19a, 19b) d'inégale profondeur.

7. Régulateur selon la revendication 1, caractérisé en ce que le branchement du régulateur à la masse du véhicule est assuré par l'intermédiaire de la connexion de branchement (8) et d'une douille métallique (22) dans laquelle pénètre librement une vis (23) de fixation du socle (1) sur la carrosserie du véhicule automobile, la tête de la vis (23) venant prendre appui sur la collerette (22a) de la douille métallique (22).

8. Régulateur selon la revendication 1, caractérisé en ce que le boitier isolant (2) comporte des moyens (30) de maintien élastique du circuit de régulation (4) dans le boitier isolant (2).

9. Régulateur selon la revendication 8, caractérisé en ce que les moyens (30) de maintien élastique du circuit de régulation (4) sont constitués de pattes venant de matière avec le boitier isolant (2), lesquelles pattes sont munies d'un becquet d'accrochage (30a).

10. Régulateur selon la revendication 1, caractérisé en ce que les moyens de fixation du boitier isolant (2) sur le socle de fixation (1) sont constitués de languettes (40), venant de matière avec le boitier isolant (2), lesquelles languettes (40) comportent une première partie (40a) d'épaisseur constante et de longueur sensiblement égale à la moitié de la longueur totale des languettes (40) et une deuxième partie extrême formant un becquet d'accrochage (40b) dans des logements (41) prévus dans le socle (1) et sur le fond de chacun desquels prend appui le becquet d'accrochage (40b).

## Patentansprüche

1. Elektrischer Regler für Wechselstrom-Lichtmaschinen von Automobilen, umfassend einen Sockel (1) zum Befestigen des Reglers an der Karosserie des Fahrzeuges, ein isolierendes Aufnahmegehäuse (2), in welchem in einem Kunststoffmaterial (3) ein Schaltkreis (4) zum Regeln der Ausgangsspannung einer Wechselstrom-Lichtmaschine eingebettet ist, Anschlußverbindungen (5, 6 und 7) für die Verteileranschlüsse (8, 9 und 10) zur Masse des Fahrzeuges und unter Zwischenschaltung von Kabeln zum Zündschloß des Fahrzeuges und zur Feldwicklung der Lichtmaschine, dadurch gekennzeichnet, daß das isolierende Gehäuse (2) Mittel (11, 40) zur Befestigung auf dem Sockel (1) mit Hilfe von daran angeordneten, entsprechenden Mitteln (20, 41) sowie Aufnahmen (12, 13, 14) für jeweils ein Ende (8b, 9b, 10b) der Verteileranschlüsse (8, 9, 10) aufweist, und daß der Sockel (1) aus einem formgegossenen, isolierenden Material Füße (15, 16) zum Befestigen desselben auf der Fahrzeugkarosserie sowie Aufnahmen (17, 18, 19) für die jeweils anderen Enden (8c, 9c, 10c) der Verteileranschlüsse (8, 9, 10) aufweist.

2. Regler nach Anspruch 1, dadurch gekennzeichnet, daß die Mittel (11) zum Befestigen des isolierenden Gehäuses (2) auf dem Sockel (1) aus an dem isolierenden Gehäuse (2) aus gleichem Material angeformten Vorsprüngen gebildet sind, wobei diese Vorsprünge jeweils einen ersten, zylindrischen Teil (11a) umfassen, deren Länge im wesentlichen der Hälfte der Länge der Vorsprünge entspricht, sowie einen zweiten, konuszylindrischen Teil (11b), dessen große Grundfläche einen gegenüber dem ersten zylindrischen Teil (11a) größeren Durchmesser hat, sowie ferner wenigstens einen Längsschlitz (11c), welcher sich über den größten Teil der Länge der Vorsprünge erstreckt.

3. Regler nach Anspruch 1, dadurch gekennzeichnet, daß die Aufnahmen (12, 13, 14) für die Enden (8b, 9b, 10b) der Verteileranschlüsse (8, 9, 10) im isolierenden Gehäuse (2) aus Gleitnuten (12a, 13a, 14a) bestehen, welche beim Formgießen des isolierenden Gehäuses (2) gebildet werden, wobei die Gleitnuten (12a, 13a, 14a) in den Wänden des isolierenden Gehäuses (2) ausgebildet sind.

4. Regler nach Anspruch 1, dadurch gekennzeichnet, daß die Aufnahme (17) für das Ende (8c) des Verteileranschlusses (8) durch die Differenz E in der Stärke des Fußes (15) und des Fußes (16) gebildet ist, wobei diese Differenz E in der Stärke beim Formgießen des Sockels (1) ausgebildet wird.

5. Regler nach Anspruch 1, dadurch gekennzeichnet, daß die Aufnahme (18) des Endes (9c) des Verteileranschlusses (9) aus einem Absatz (18a) gebildet ist, welcher beim Formgießen des Sockels (1) ausgebildet wird.

6. Regler nach Anspruch 1, dadurch gekennzeichnet, daß die Aufnahme (19) des Endes (10c) des Verteileranschlusses (10) durch eine Ausnehmung gebildet ist, welche im Sockel (1) beim Formgießen desselben vorgesehen wird, wobei diese Ausnehmung zwei Bereiche (19a, 19b) unterschiedlicher Tiefe aufweist.

7. Regler nach Anspruch 1, dadurch gekennzeichnet, daß der Anschluß des Reglers an die Masse des Fahrzeuges durch den Verteileranschluß (8) und eine Metallhülse (22) gebildet wird, durch die eine Schraube (23) zum Befestigen des Sockels (1) auf der Automobilkarosserie frei hindurchtritt, wobei der Kopf dieser Schraube (23) auf dem Bund (22a) der Metallhülse (22) zur Anlage kommt.

8. Regler nach Anspruch 1, dadurch gekennzeichnet, daß das isolierende Gehäuse elastische Mittel (30) zum Halten des Regelschaltkreises (4) im isolierenden Gehäuse (2) aufweist.

9. Regler nach Anspruch 8, dadurch gekennzeichnet, daß die elastischen Mittel (30) zum Halten des Regelschaltkreises (4) aus Fingern gebildet sind, die an das isolierende Gehäuse aus gleichem Material angeformt sind, wobei diese Finger jeweils mit einem Hakenfortsatz (30a) versehen sind.

10. Regler nach Anspruch 1, dadurch gekennzeichnet, daß die Mittel zum Befestigen des isolierenden Gehäuses (2) auf dem Befestigungssockel (1) aus Zungen (40) gebildet sind, die an das isolierende Gehäuse (2) aus gleichem Material angeformt sind, wobei die Zungen (4) einen ersten Teil (40) mit konstanter Dicke und einer Länge umfassen, die im wesentlichen gleich der Hälfte der Gesamtlänge der Zungen ist, sowie einen zweiten Endteil, welcher jeweils einen Hakenfortsatz (40b) zum Einhaken in im Sockel (1) ausgebildete Ausnehmungen (41) bildet, wobei der Hakenfortsatz (40b) sich jeweils an den Boden der Ausnehmungen (41) anlegt.

## Claims

1. An electronic regulator for automobile vehicle alternators, comprising a base (1) for fixing the regulator to the vehicle bodywork, an insulating housing or hood (2) in which there is embedded, in a resin (3), a regulation circuit (4) for the output voltage of an alternator, lines (5, 6, 7) for connection to junction connections (8, 9, 10) to the vehicle earth and, via cables, to the ignition key of the vehicle and to the field winding of the alternator, characterised in that the insulating housing (2) comprises means (11, 40) for fastening to the base (1) by means of corresponding means (20, 41) of the latter, means for housing (12, 13, 14) of one end (8b, 9b, 10b) of each of the junction connections (8, 9, 10) and in that the base (1) of moulded insulating material comprises lugs (15, 16) for fastening to the vehicle bodywork and housing means (17, 18, 19) for each of the other ends (8c, 9c, 10c) of the junction connections (8, 9, 10).

2. A regulator as claimed in claim 1, characterised in that the means (11) for fastening of the insulating housing (2) to the base (1) are formed by projections rigid with the insulating housing (2), which projections comprise a first cylindrical portion (11a) having a length substantially equal to half the length of the projections and a second frustoconical portion (11b) whose larger side has a greater diameter than the first cylindrical portion (11a), at least one longitudinal slot (11c) being provided over the majority of the length of the projections.

3. A regulator as claimed in claim 1, characterised in that the means (12, 13, 14) for housing the ends (8b, 9b, 10b) of the junction connections (8, 9, 10) in the insulating housing (2) are formed by slideways (12a, 13a, 14a) obtained during the moulding of the insulating housing (2), which slideways (12a, 13a, 14a) are provided in the walls of the insulating housing (2).

4. A regulator as claimed in claim 1, characterised in that the means (17) for housing the end (8c) of the junction connection (8) is formed by the difference in thickness E of the lug (15) with respect to the lug (16), which difference in thickness E is obtained during the moulding of the base (1).

5. A regulator as claimed in claim 1, characterised in that the means (18) for housing the end (9c) of the junction connection (9) is formed by a recess (18a) obtained during the moulding of the base (1).

6. A regulator as claimed in claim 1, characterised in that the means (19) for housing the end (10c) of the junction connection (10) is formed by a recess provided in the base (1) during its moulding, which recess has two portions (19a, 19b) of different depth.

7. A regulator as claimed in claim 1, characterised in that the connection of the regulator to the vehicle earth is carried out via the junction connection (8) and a metal dowel (22) into which there freely penetrates a screw (23) for the fastening of the base (1) to the automobile vehicle bodywork, the head of the screw (23) being supported on the collar (22a) of the metal dowel (22).

8. A regulator as claimed in claim 1, characterised in that the insulating housing (2) comprises means (30) for resiliently holding the regulation circuit (4) in the insulating housing (2).

9. A regulator as claimed in claim 8, characterised in that the means (30) for resiliently holding the regulation circuit (4) are formed by lugs rigid with the insulating housing (2), which lugs are provided with a catch hook (30a).

10. A regulator as claimed in claim 1, characterised in that the means for fastening the insulating housing (2) to the fastening base (1) are formed by tongues (40) rigid with the insulating housing (2), which tongues (40) comprise a first portion (40a) having a constant thickness and a length substantially equal to half the total length of the tongues (40) and a second end portion forming a catch hook (40b) in the housings (41) provided in the base (1) and at the base of which the catch hook (40b) is supported.

0 093 029

_FIG. 1_

_FIG. 2_

_FIG. 3_

_FIG. 4_

7

## _FIG. 5_

## _FIG. 6_

## _FIG. 7_

## _FIG. 8_

## _FIG. 9_